# EUROPEAN PATENT APPLICATION

(11) **EP 1 321 946 A2**
(43) Date of publication of application: **25.06.2003**
(21) Application number: 02258478.3
(22) Date of filing: 09.12.2002
(51) Int. Cl.: G11C 27/02

(54) **High speed differential data sampling circuit**

(30) Priority: 21.12.2001 US 37967
(71) Applicant: STMicroelectronics, Inc., Carrollton Texas 75006-5039 (US)
(72) Inventor: Chow, James, Pal Alto, California 94303 (US); Lay, Khin, San Jose, California 95131 (US); Wen, Kenny D., San Jose, California 95148 (US)
(74) Representative: Style, Kelda Camilla Karen

(57) **Abstract**

A differential data sampling circuit is provided for sampling an input signal line with precise timing so as to provide reduced sensitivity to noise. The differential data sampling circuit includes a latch circuit for initially sampling a differential data signal in response to a first strobe signal. The latch circuit operates to rapidly capture the signal level present on the input signal line. The output of the latch circuit is then sampled by a strobe circuit in order to capture and hold the output of the latch circuit based on a second strobe signal. In preferred embodiments, the latch circuit has a high input impedance. A digital data receiver including such a differential data sampling circuit is also provided.

## Description

The present invention relates to sample and hold circuits, and more specifically to a system and method for precisely sampling electrical signals.

Digital data communication between two electrical circuits involves the transmission of a signal that communicates the digital data. The signal received by an electronic device is often encoded using different voltages on an electrical signal line. A signal line is used to communicate a single data bit at a time by carrying two voltage levels, which each represent one of two levels that correspond to the two states of a data bit. A signal line that carries more that two voltage levels represents more than one bit (e.g., one of eight possible voltage levels is used to communicate three data bits at a time). A voltage level on a signal line is referred to as a symbol and each symbol represents one or more bits according to the number of possible voltage levels.

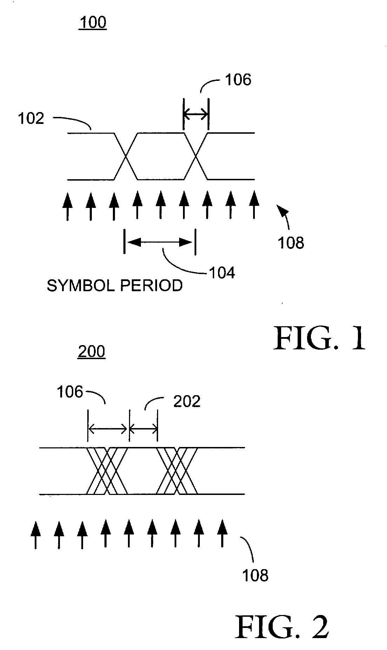

Serial data communications transmit multiple data symbols in a time division manner. Each symbol (i.e., voltage level) is present on the signal line for a fixed time period that is referred to as a symbol period. Subsequent symbol periods are used to transmit other data symbols. An example time graph 100 of voltages on a two voltage level communications line is illustrated in FIG. 1. The example time graph 100 illustrates the superposition of an aggregation of voltage levels 102 that exist over several time periods and which are superimposed upon each other to allow easier comparison of symbol periods 104 for different symbols (i.e., the example time graph 100 shows signals with both the high and low voltage levels).

A digital data receiver samples the signal line during each symbol period 104 to determine the transmitted symbol and re-assemble the communicated data stream. The communication of serial data over bandwidth limited circuits results in finite rise and fall times 106 between symbols, which produces less than optimal signal sampling near the time between symbol periods. Electrical noise on the signal line also induces errors in determining the transmitted voltage level, and those errors induce errors in the detected data output that is produced by the receiver. Sampling the data signal within the signal rise and fall time 106 that occurs in the time region near the symbol transition time therefore increases the probability of an erroneous data determination being made by the receiver.

The example time graph 100 illustrates multiple sample strobes 108. Each sample strobe 108 indicates when the receiver samples the voltage on the signal line to determine the voltage level and decide which data symbol was transmitted. The sample strobes 108 of the example time graph 100 illustratively show three sample strobes contained within each symbol time 104. This oversampling is used to account for any lack of synchronization of the timing of the sample strobes within the receiver with the symbol time 104. The use of such multiple sample strobes during the symbol time increases the probability of having at least one sample strobe occurring in the middle region of the symbol time 104 (i.e., not within the rise and fall time 106).

In addition to the data signal, digital data communication between electrical circuits in the same device or in different devices sometimes includes the simultaneous communication of a data clock signal. The data clock signal allows the receiver to synchronize the sample strobes 108 to the symbol time 104 in order to sample the signal line at the proper time. Data communications systems typically use data clock signals that provide either an indication of each symbol time 104 or an indication of every Nth symbol time 104. For example, one system provides a data clock signal that indicates when to sample every thirty-second symbol. Providing a data clock signal that indicates every Nth symbol reduces the bandwidth required for the data clock circuit but requires generation within the receiver of a higher rate sample clock to trigger the sampling of every symbol.

The data clock signal that originates from a transmitter is synchronized to the data signal. Differences in cable lengths, printed circuit board traces and internal circuit signal propagation delay between the circuits carrying the data signal and the data clock signal cause skewing of the time relationship between the data signal and data clock signal. Electrical noise on the data clock signal line also induces a dynamic jitter into the data clock signal. Electrical noise on the data signal line also causes an apparent jitter in the transitions of data symbol levels in the data signal. An example symbol transition time jitter graph 200 is shown in FIG. 2. The example symbol transition time jitter graph 200 shows the decreased duration of the stable symbol level period 202 and a resulting increase in the duration of the rise and fall times 106 during which the data signal voltage level is uncertain. Oversampling of the data signal line, as in the example time graph 100 with sample strobes 108 that have three sample strobes per symbol time 104, accommodates this sampling time uncertainty.

However, in high symbol rate systems, the number of samples which are able to be made during each symbol period is limited by the sampling speed of practical sampling circuits. Increasing the number of samples per symbol period also increases the amount of sampling hardware required and the processing required to handle the increased number of samples, all of which increases the cost of the receiver. While the number of samples per period is practically limited, an error in the sample timing of one sixth of the symbol period in an example high symbol rate system that samples the input signal three times per symbol period results in one sample occurring during the bit transition and the other two occurring at equally spaced intervals between the symbol transition and the symbol midpoint. The sampling of the input signal at such a point midway between the symbol transition and the symbol period midpoint possibly places those samples in the signal rise and fall times and increases the probability of symbol decision errors due to noise. Timing skew and jitter that affects the received data clock, in combination with a limited bandwidth for the data signal, often reduces the period of time within the symbol period that the data signal is at a stable level. This reduction in the period of time that the data signal is stable (and thus able to be effectively sampled), increases the susceptibility to noise and degrades the performance of the data receiver.

Further, practical data receivers that process high speed digital data often incorporate multiple signal sampling circuits (i.e., sample and hold circuits). These multiple sample and hold circuits each sample the signal line at different times and hold the sampled voltage at output. In the case of oversampling, the sample and hold outputs are processed to determine which set of samples are the best to use in recovering the communicated data. In the case of a system that transmits multiple symbols during each data clock cycle ( i.e., a data clock signal is transmitted once every Nth data symbol), a synthetic clock is generated to allow capture of each symbol that occurs between the pulses of the data clock signal. These multiple sample circuits are driven in parallel and place a large load upon the circuit driving the multiple sample circuits. The output requirements of the circuit driving the multiple sample circuits is reduced if the input impedance into the multiple sample circuits is reduced.

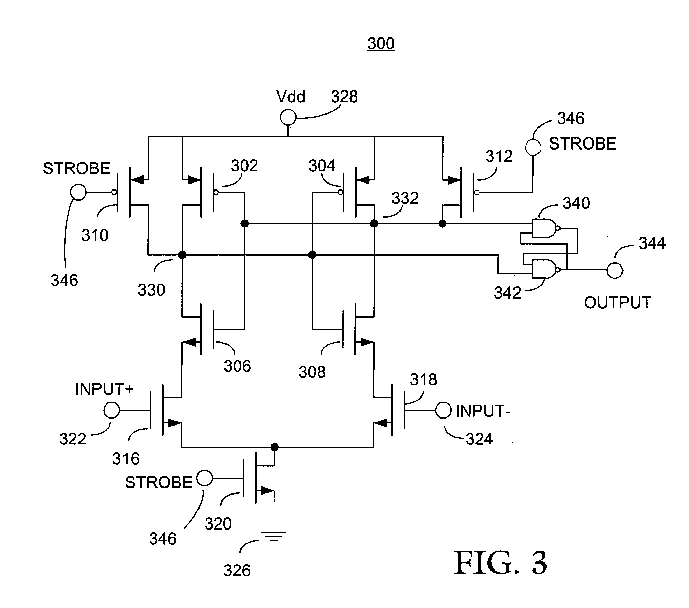

An example of a conventional sample and hold circuit is illustrated in FIG. 3. This type of circuit is known as a strobe circuit. Example strobe circuit 300 accepts an input coded as a differential voltage signal that is represented at input+ 322 and input- 324. The two input signals, input+ 322 and input- 324, carry complementary voltage values. Such differential signal transmission provides benefits for transmission of voltage levels and processing of those signals by receiving circuits. Strobe circuit 300 accepts the voltage inputs input+ 322 and input- 324 and a strobe input 346. The strobe input 346 signals when the strobe circuit 300 is to sample the inputs and hold the sampled value at output 344. Strobe circuit 300 is powered by a Vdd input 328 and a circuit ground connection 326.

The operation of the strobe circuit 300 begins with the strobe input 346 equal to a low logic level, and the logic level of the input is sampled and held when the strobe input 346 transitions to a high logic level. When the strobe input 346 is equal to the low logic level, a first strobe transistor 310 and a second strobe transistor 312, which are driven at their gates by an inverse level of the strobe input signal 346, conduct and hold a first state node 330 and a second state node 332 close to Vdd. This results in no conduction through a first drive transistor 302 and a second drive transistor 304 because they are driven at their gates by an inverse of the second state node 332 and the first state node 330, respectively. The strobe input 346 also directly drives a third strobe transistor 320 at its gate. When the strobe input 346 is equal to the low logic level, the third strobe transistor 320 does not conduct. This results in the first state node 330 and the second state node 332 being held close to Vdd while the strobe input 346 is equal to the low logic level.

The strobe circuit 300 samples and holds the input voltage present on input+ 322 and input- 324 when the strobe input 346 transitions from low to high. When the strobe input 346 transitions from low to high, the first strobe transistor 310 and the second strobe transistor 312 cease to conduct. The third strobe transistor 320 does conduct and provides a path from the sources of the two input transistors, positive input transistor 316 and inverse input transistor 318. Upon the transition from low to high, the first state node 330 and the second state node 332 have a high logic level. This results in an initial positive bias on the gates of both the third drive transistor 306 and the fourth drive transistor 308. The current conducted by the third drive transistor 306 and the fourth drive transistor 308 is governed by the relative bias that is connected to the gates of the positive input transistor 316 and the inverse input transistor 318.

Since the input+ 322 and input- 324 signals are at complementary voltage levels, one of the input transistors (positive input transistor 322 or inverse input transistor 324) will conduct more than the other and cause one of the state nodes (either the first state node 330 or second state node 332) to be pulled to a lower voltage than the other. The drive transistors (first drive transistor 302, second drive transistor 304, third drive transistor 306, and fourth drive transistor 308) act upon the voltage imbalance between the first state node 330 and the second state node 332 to create a conditioned input to the NAND logic gate pair of a first NAND gate 340 and a second NAND gate 342. The NAND logic gate pair provides a latched output 344 representing the logic level received at the input to the strobe circuit 300 on input+ 322 and input- 324.

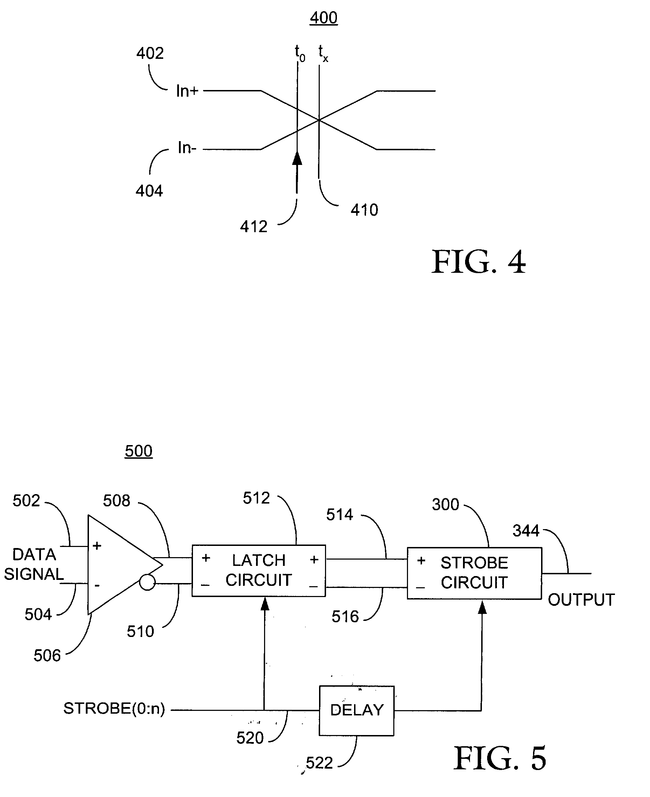

Such a strobe circuit encounters difficulties when the strobe input 346 transitions from low to high when the input voltage levels on input+ 322 and input- 324 are in transition between states, which occurs between symbols. A detailed view of an example input signal voltage level transition 400, which shows the voltage levels on input+ 322 and input- 324, is shown in FIG. 4. The two complementary voltages, the In+ voltage 402 that corresponds to the voltage on input+ 322 and the In- voltage 404 that corresponds to the voltage on input- 324, are shown during the time near the symbol transition time 410.

A low to high strobe transition to 412 of the strobe signal 346 that activates the strobe circuit 300 is shown to slightly precede the symbol transition time 410, but occurs after the voltage levels In+ 402 and In- 404 have begun to change. In this example case, inaccuracies in the operation of the strobe circuit 300 occur because the voltage difference between In+ 402 and In- 404 is smaller than during the middle of the symbol period, and is decreasing for the time after the strobe transition 412. This smaller input voltage difference causes less of a difference in the conduction of the positive input transistor 316 and the inverse input transistor 318, and thus results in slower changes in the voltage levels at the first state node 330 and the second state node 332.

The capacitances of the circuits and components which make up such a strobe circuit restrict the speed with which the voltages change in the circuit. The inability to rapidly change voltage levels within the strobe circuit especially degrades the performance of strobe circuits which operate with input voltage levels (e.g., input signals In+ 402 and In+ 404) that have a small and decreasing difference, as is illustrated in the example input signal voltage level transitions of FIG. 4.

In view of these drawbacks, it is an object of the present invention to remove the above-mentioned drawbacks and to provide an electrical signal sampling circuit that achieves increased accuracy.

Another object of the present invention is to provide an electrical signal sampling circuit that is better able to tolerate decreases in the differential input signal voltage difference, such as occur near the time of data symbol transitions.

A high speed differential sampling circuit according to one preferred embodiment of the present invention includes a latch circuit that latches the data on a signal line, and a strobe circuit that captures the signal level that is present at the output of the latch circuit. The strobe circuit also conditions the signal level so as to produce an output level that is compatible with logic circuitry.

Other objects, features, and advantages of the present invention will become apparent from the following detailed description. It should be understood, however, that the detailed description and specific examples, while indicating preferred embodiments of the present invention, are given by way of illustration only and various modifications may naturally be performed without deviating from the present invention.
FIG. 1 is a voltage verses time plot of a superposition of input signal levels and signal sample time points for multiple symbol periods;
FIG. 2 is an illustration of voltage verses time of a superposition of input signal levels and sample times for multiple symbol periods where the input signal exhibits time jitter;
FIG. 3 is a schematic diagram of a conventional strobe circuit;
FIG. 4 is a more detailed voltage verses time plot of an input signal level illustrating bit transition time;
FIG. 5 is a schematic diagram of a data sampling circuit according to one embodiment of the present invention;
FIG. 6 is a schematic diagram of a latch circuit that is utilized as a processing stage in a preferred embodiment of the present invention; and
FIGs. 7A, 7B and 7C show the load elements utilized in some exemplary embodiments of the present invention.

Preferred embodiments of the present invention will be described in detail hereinbelow with reference to the attached drawings.

A high speed differential data sampling circuit 500 according to one embodiment of the present invention is illustrated in FIG. 5. The high speed differential data sampling circuit 500 receives a differential input signal at inputs In+ 502 and In- 504 of a high speed differential buffer 506 which acts as a line receiver and signal amplifier. Alternative embodiments of the present invention provide a single input data signal 502 as an input into the high speed differential buffer 506 and supply a reference voltage to the In- input 504. The buffer 506 produces a two signal line differential output that is able to drive multiple downstream circuits, such as multiple sampling circuits that each sample signal levels at different sample times. The output of the buffer 506 is a buffer positive output 508 and a buffer inverse output 510. The buffer positive output 508 and buffer inverse output 510 each reflect the voltage level of the input signal of the buffer 506. These two output signals contain complementary voltage levels and provide advantages to transmission and reception of the differential signal.

The differential buffer output of buffer positive output 508 and buffer inverse output 510 is transmitted to a latch circuit 512 in the illustrated embodiment of the present invention. The latch circuit 512 samples and holds the input voltage at a sample time. The latch circuit 512 is configured to provide a conditioned output voltage that is stable and free of noise variations. The latch circuit 512 of the illustrated embodiment is also configured to produce an output voltage with a low voltage swing in order to improve the response time of the latch circuit 512 and increase the operating frequency over which the entire high speed differential data sampling circuit 500 can operate.

The latch circuit 512 of the illustrated embodiment of the present invention is controlled by one of n strobe signals, which is present among a strobe signal bus STROBE(0:n) 520. The illustrated embodiment operates by receiving a data clock signal that indicates each nth data symbol transition. The data receiver generates n strobe signals based upon the received data clock signal (with circuitry that is not shown). The strobe signal bus STROBE (0:n) 520 delivers one of the n clock signals to each latch circuit 512. The strobe signal that is used to trigger the latch circuit 512 is delayed by a delay element 522 before being supplied to a strobe circuit 300. The use of a strobe signal that is delayed from the strobe signal input to the latch circuit 512 allows the output of the latch circuit 512 to settle prior to capture by the strobe circuit 300.

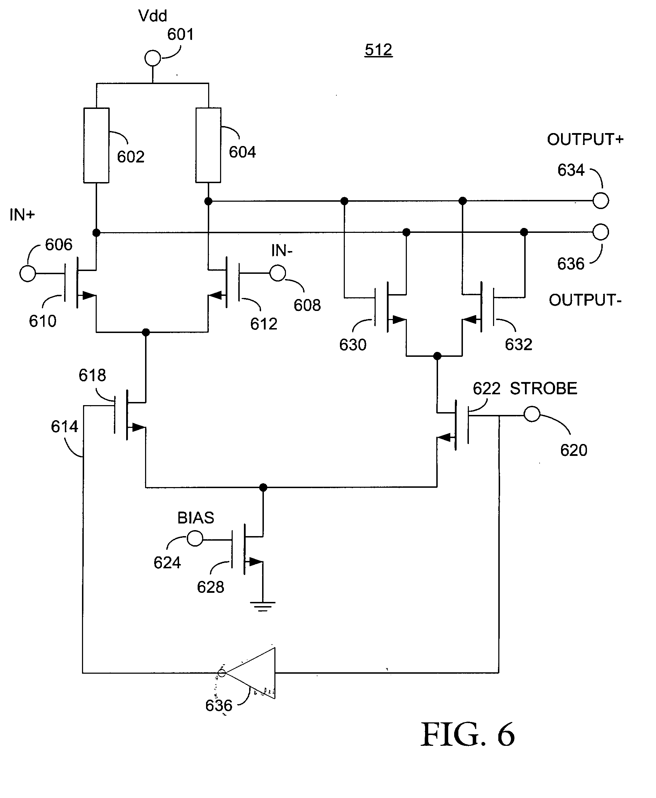

The detailed design and operation of the latch circuit utilized in one preferred embodiment of the present invention is described below with reference to FIG. 6. Alternative embodiments of the present invention use one or more of any latch circuit that can operate to latch a representation of the voltage that is present at input in response to a strobe input and hold a representation of that input at output. For example, one alternative embodiment of the present invention utilizes the latch circuit of U.S. Patent No. 5,625,308, which is herein incorporated by reference. The latch circuit that is utilized in embodiments of the present invention is only required to produce an output that is representative of the input voltage, the exact input voltage is not required to be maintained at the latch output.

The output of the latch 512 is transmitted on a two line differential output of the latch positive output 514 and the latch inverse output 516. This differential output operates similarly to the buffer differential output transmitted on the buffer positive output 508 and the buffer inverse output 510. The latch positive output 514 and the latch inverse output 516 in the illustrated embodiment are supplied to a strobe circuit 300. The strobe circuit 300 of the preferred embodiment is controlled by the same strobe signal from the strobe signal bus STROBE(0:n) as the latch circuit 512. The strobe circuit 300 utilized in embodiments of the present invention can be any strobe circuit that can operate to sample and hold an input signal based on a strobe signal, such as the strobe circuit of FIG. 3.

Embodiments of the present invention provide a latch circuit 512 prior to the strobe circuit 300 in order to reduce the duration of the rise and fall times 106 at the input of the strobe circuit 300 and to provide a stable input voltage that does not contain any noise present on the input to the buffer 506. This increases the time span over which the strobe circuit 300 is able to effectively sample an input signal. Further, the latch circuit 512 and the strobe circuit 300 are preferably fabricated on a single semiconductor die in order to minimize the distortion of the latch output signal. Minimizing the distortion on the input signal to the strobe circuit minimizes the time period over which the strobe circuit 300 has difficulty in sampling its input signal (as described above).

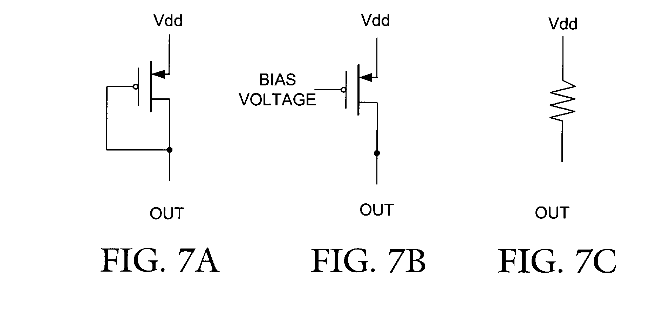

A schematic diagram of the latch circuit 512 used in one preferred embodiment is illustrated in FIG. 6. The latch circuit 512 has two branches, an input branch and a latch branch, that operate under the control of a strobe input 620 and a strobe_b signal 614, which is the logical inverse of the strobe input 620 as produced by an inverter 636 that receives the strobe input 620. Both branches are driven by an input power supply voltage Vdd, which is connected through two load elements, positive load 602 and inverse load 604, to two differential output nodes, out+ 634 and out- 636. Preferred embodiments of the latch circuit use active load elements based upon MOS transistors incorporated into the semiconductor substrate, as shown in FIGs. 7A. Other embodiments use load elements based upon a bias voltage or a resistive element, such as those shown in FIGs. 7B and 7C. The load elements utilized in further embodiments of the present invention can be any known load elements.

The input branch of latch circuit 512 accepts differential signal inputs In+ 606 and In- 608 at the gate terminal of the signal input transistors, In+ transistor 610 and In-transistor 612. The signal input transistors selectively conduct current from the output nodes to ground so as to control the voltage at the output nodes by inducing a voltage drop across one of the load elements. The current flow through the signal input transistors of the first branch is controlled by strobe_b transistor 618 and bias transistor 628. The gate of the strobe_b transistor 618 is driven by the strobe_b signal 614 and the gate of the bias transistor 628 is driven by the bias input 624. When the strobe_b input 614 is driven to a high logic level, the strobe_b transistor 618 is able to conduct. The bias input 624 is an analog input and is configured to cause a desired bias current to flow through bias transistor 628, which also sets the current flow through the two branches of the circuit.

The differential inputs In+ 606 and In- 608 are driven to complementary voltage levels in order to implement the differential electrical interface. This results in either the In+ transistor 610 or the In- transistor 612 being driven with a high voltage level at its gate and therefore conducting when the strobe_b signal is high. The other input transistor in this arrangement is therefore driven with a low voltage level and does not conduct, or conducts much less current. This configuration causes current to flow through one of the load elements, positive load element 602 or inverse load element 604, in response to conduction of current through the associated input transistor.

In the case of a positive input signal and assertion of the strobe_b signal 614, the In+ signal 606 is at a high voltage level and causes current to flow through the positive input transistor 610 and positive load element 602. This results in a low voltage output at inverse output 636. In the case of a positive input signal, the In- input 608 is at a low voltage, resulting in little or no current flow through the inverse load element 604, and therefore a high voltage output at positive output 634. In the case of a negative input signal, the In+ input 606 is low and no current flows through positive input transistor 610 while the In- input 608 is high and causes current to flow through inverse load 604 and inverse input transistor 612. This configuration results in a high voltage level at the inverse output 636 and a low voltage level at the positive output 634.

The voltages that are present at the output, the positive output 634 and inverse output 636, are influenced by the bias input 624 and the resulting current that flows through bias transistor 628. The bias current flowing through the bias transistor 628 is equal to the current that flows through the load elements, positive load element 602 and inverse load element 604. A lower bias current results in a smaller voltage drop across the load elements and thus smaller voltage changes at the outputs (i.e., the positive output 634 and inverse output 635). Operating the latch circuit 512 with a low output voltage swing improves the speed with which the circuit recovers from holding the output in the latched mode and the transition to the through mode when the input voltage levels are reflected at the latch outputs.

The latch circuit 512 of the preferred embodiment samples and holds the input value when the strobe input 620 transitions from a low voltage value to a high voltage value. The sampling and holding of the output of the latch circuit 512 is performed by the operation of the latch branch. Upon the transition of the strobe input 620 from low to high, the strobe_b signal transitions to a low voltage level and causes the strobe_b transistor to stop conducting. The strobe transistor 622 is now able to conduct because the strobe input 620 is at a high voltage level.

The second branch of the latch circuit 512 includes the hold transistors, inverse hold transistor 630 and positive hold transistor 632, along with the load elements, strobe transistor 622 and bias transistor 628. The second circuit branch has the hold transistors configured so as to have cross-coupled drain and gate terminals that are connected to the positive output 634 and inverse output 636. The hold transistors operate by providing positive feedback to one another so as to maintain a differential voltage output at the output of the latch circuit 512 in conjunction with drawing current through one of the load elements.

Accordingly, embodiments of the present invention provide high speed differential data sampling circuits that utilize an initial latch circuit stage coupled to a strobe circuit stage. The initial latch circuit stage provides a quick reacting voltage sampling of the input signal so as to sample and hold the input voltage in response to a strobe signal. The subsequent strobe circuit stage processes the output of the latch circuit, also in response to a strobe signal, in order to provide an output that is compatible with the digital logic circuits within a device. This combination of an initial latch circuit stage and a subsequent strobe circuit stage produces a rapidly responding data sampling circuit that is able to provide a large output voltage swing even for differential input voltages that have minimal voltage separation near symbol transitions.

While there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above. Therefore, it is intended that the present invention not be limited to the particular embodiments disclosed, but that the invention include all embodiments falling within the scope of the appended claims.

## Claims

1. A differential data sampling circuit comprising:
a latch circuit for sampling a differential data signal in response to a first strobe signal; and
a strobe circuit coupled to the latch circuit, the strobe circuit capturing the output of the latch circuit based on a second strobe signal.

2. The differential data sampling circuit according to claim 1, wherein the first strobe signal and the second strobe signal are the same signal.

3. The differential data sampling circuit according to claim 1 or 2, wherein the latch circuit includes load elements, and each of the load elements includes a diode-connected transistor.

4. A digital data receiver including at least one differential data sampling circuit, said differential data sampling circuit comprising:
a latch circuit for sampling a differential data signal in response to a first strobe signal; and
a strobe circuit coupled to the latch circuit, the strobe circuit capturing the output of the latch circuit based on a second strobe signal.

5. The circuit or digital data receiver according to any preceding claim, wherein the latch circuit produces a voltage change at output that is less than the voltage difference between a power supply voltage that supplies the latch circuit and ground.

6. The circuit or digital data receiver according to any preceding claim,
wherein the latch circuit is an analog latch circuit that latches the differential data signal in response to the first strobe signal so as to produce a latched voltage, and
the strobe circuit samples and holds the latched voltage in order to determine a logic level of the differential data signal.

7. The circuit or digital data receiver according to claim 1 or 4, wherein the first strobe signal is delayed to produce the second strobe signal.

8. The circuit or digital data receiver according to any preceding claim, wherein the latch circuit includes:
an input branch and a latch branch connected in parallel; and
a bias current control transistor coupled in series with both the input branch and the latch branch.

9. The circuit or digital data receiver according to claim 8, wherein the input branch of the latch circuit includes:
a pair of differential input transistors; and
a single strobe transistor coupled in series with the pair of differential input transistors.

10. The circuit or digital data receiver according to any preceding claim, wherein the latch circuit receives only one bias voltage.

11. The circuit or digital data receiver according to any preceding claim, wherein the differential data sampling circuit further includes a high speed differential buffer having an output coupled to the input of the latch circuit, the high speed differential buffer receiving a differential input signal.

12. The circuit or digital data receiver according to claim 11, wherein the differential input signal received by the high speed differential buffer is composed of a single input data signal and a reference voltage.
